# DEMANDE DE BREVET EUROPEEN

(11) **EP 0 952 612 A1**
(43) Date de publication de la demande: **27.10.1999**
(21) Numéro de dépôt: 99420102.8
(22) Date de dépôt: 21.04.1999
(51) Int. Cl.: H01L 23/427, F28F 13/00, F28D 15/02

(54) **Echangeur de chaleur, notamment pour le refroidissement d'un composant électronique de puissance, et son procédé de fabrication**

(30) Priorité: 23.04.1998 FR 9805340
(71) Demandeur: Ferraz Date Industries, 38350 La Mure (FR)
(72) Inventeur: Julien, Jean-Noel, 69780 Mions (FR); Chiousse, Michel, 38230 Tignieu (FR)
(74) Mandataire: Myon, Gérard Jean-Pierre

(57) **Abrégé**

Echangeur de chaleur, notamment pour le refroidissement d'un composant électronique du puissance (3), ledit échangeur comprenant une plaque (1), réalisée dans un premier matériau métallique et pourvue, sur une première face d'échange thermique (la), de gorges (4) de réception de tubes (5) de circulation d'un fluide caloporteur, lesdits tubes (5) étant réalisés dans un second matériau métallique, caractérisé en ce que lesdites gorges (4) sont revêtues d'un dépôt métallique (10) obtenu par projection d'un métal ou d'un alliage de métal en fusion dans lesdites gorges (4), ledit dépôt (10) ayant une composition permettant une fixation desdits tubes (5) sur ledit dépôt (10) par brasage ou soudage.

Le procédé consiste à projeter dans les gorges, avant mise en place des tubes (5), un dépôt (10) de métal ou d'alliage de métal en fusion, notamment grâce à un jet d'air comprimé.

## Description

L'invention a trait à un échangeur de chaleur, notamment pour le refroidissement d'un composant électronique de puissance, et à son procédé de fabrication.

Des échangeurs de chaleur sont nécessaires pour éviter un échauffement dommageable de composants électroniques de puissance tels que des circuits IGBT ("Insulated Gate Bipolar Transistor" ou "Transistor Bipolaire à Gachette Isolée") ou équivalents. Un échangeur de chaleur comprenant plusieurs tubes d'évaporation/condensation d'un liquide caloporteur et un bloc formant unité d'échange thermique avec un composant électronique est décrit dans la demande de brevet Européen 417 299. Par ailleurs, WO-A-95/17 765 divulgue un échangeur de chaleur comprenant une plaque pourvue de gorges de réception de tubes de circulation d'un liquide caloporteur.

D'un point de vue technique et sur le plan économique, il est avantageux de réaliser en aluminium une plaque dans laquelle sont prévues des gorges de réception de tubes. En effet, ce matériau présente de bonnes propriétés thermiques, une usinabilité et une stabilité dimensionnelle satisfaisantes, alors que son prix de revient est attractif. D'autre part, il est de pratique courante de réaliser des tubes de circulation de fluide caloporteur en cuivre ou en alliage de cuivre, ce matériau étant compatible avec la plupart des fluides caloporteurs et pouvant être conformé de façon relativement aisée, alors que son prix de revient est également attractif.

Or, l'aluminium de la plaque et le cuivre des tubes ne sont pas compatibles, au point qu'il n'est généralement pas possible de souder ou de braser directement un tube en cuivre sur une plaque en aluminium. Ceci n'est pas acceptable pour l'application considérée car il convient d'immobiliser les tubes par rapport à la plaque qui les supporte. C'est pourquoi il est d'usage de nickeler la surface extérieure d'une plaque en aluminium par électrolyse afin de permettre le brasage ou le soudage des tubes en cuivre sur les surfaces nickelées de cette plaque.

Si elle permet de résoudre le problème de l'accrochage des tubes sur la plaque, cette approche présente néanmoins l'inconvénient d'une consommation importante de nickel puisque l'ensemble de la plaque est revêtu de nickel, y compris les surfaces qui ne sont pas destinées à recevoir un tube en cuivre. Par ailleurs, ce nickelage a pour effet de dégrader le transfert thermique, par exemple entre un composant électronique de puissance et la plaque, ce qui diminue les performances globales de l'échangeur.

Enfin, un tel procédé n'est pas nécessairement applicable lorsque la plaque est de dimensions importantes, notamment plus importantes que les dimensions transversales du bain d'électrolyse. Ce dernier inconvénient est particulièrement sensible lorsque l'échangeur de chaleur est prévu pour être utilisé dans le domaine des panneaux solaires où l'énergie du rayonnement solaire est récupérée grâce à un fluide caloporteur circulant dans les tubes disposés dans des gorges supportées par une plaque. Ces panneaux peuvent atteindre plusieurs mètres de long ou de large.

C'est à ces inconvénients qu'entend plus particulièrement remédier l'invention en proposant un échangeur de chaleur dans lequel la fixation de tubes sur une plaque support peut être réalisée de façon efficace, sans dégradation des performances thermiques globales de l'échangeur.

Dans cet esprit, l'invention concerne un échangeur de chaleur, notamment pour le refroidissement d'un composant électronique de puissance, cet échangeur comprenant une plaque, réalisée dans un premier matériau métallique et pourvue, sur une première face d'échange thermique, de gorges de réception de tubes de circulation d'un fluide caloporteur, ces tubes étant réalisés dans un second matériau métallique, caractérisé en ce que les gorges sont revêtues d'un dépôt métallique obtenu par projection d'un métal ou d'un alliage de métal en fusion dans les gorges, ce dépôt ayant une composition permettant une fixation des tubes sur le dépôt par brasage ou soudage.

Grâce à l'invention, le dépôt est confiné dans les seules zones où il est utile, de sorte que la masse totale de métal déposé est moindre. Ceci est plus économique et permet un contact direct entre la face d'échange thermique de la plaque et la source de chaleur ou de froid, à l'extérieur des gorges. La composition du dépôt du métal peut être identique à celle des tubes, ce qui garantit un accrochage efficace par soudage ou par brasage entre les tubes et le dépôt. La composition du dépôt peut également être différente de celle des tubes, pour autant qu'elle permet un tel brasage ou soudage. L'accrochage de la couche formant le dépôt de métal sur le fond des gorges n'est pas réalisé par brasage ou par soudage, mais résulte d'un accrochage mécanique intime.

Selon un premier aspect de l'invention, le dépôt métallique a une épaisseur comprise entre 0,01 et 0,5 mm, de préférence de 0,04 mm. On peut prévoir que, lorsque les tubes sont en cuivre, le dépôt est un dépôt de cuivre, d'étain, de nickel ou d'un alliage de ces métaux.

Selon un autre aspect avantageux de l'invention, les tubes reçus dans les gorges sont conformés par écrasement, de telle sorte qu'ils ne dépassent pas de la première face de la plaque à l'extérieur de ces gorges. Ceci permet de plaquer une source de chaleur ou de froid directement sur les tubes, par exemple lorsqu'ils ont une surface exposée globalement parallèle à la première face de la plaque.

Selon un autre aspect particulièrement avantageux de l'invention, le fond de l'une au moins des gorges est pourvu d'au moins un orifice débouchant sur une seconde face de la plaque opposée à la première face, un tube secondaire s'étendant à travers de cet orifice à l'opposé de la première face, ce tube étant connecté à un tube primaire reçu dans la gorge. Cet aspect de l'invention permet de dissiper la chaleur collectée par le tube primaire reçu dans une gorge de la plaque au moyen d'un ou plusieurs tubes secondaires raccordés sur celui-ci à travers les orifices débouchant sur la seconde face de la plaque. Cet arrangement, particulièrement compact, permet de réaliser un échangeur de chaleur comprenant une plaque sur une première face de laquelle peuvent être disposées des sources de chaleur, telles que des composants électroniques de puissance, alors que des moyens de dissipation de cette chaleur sont disposés sur une face arrière de cette plaque. Un tel arrangement est particulièrement utile pour la construction d'une face arrière d'une armoire électronique.

Dans ce cas, on peut prévoir que le tube secondaire s'étendant à travers l'orifice débouchant est conformé de telle sorte que, en position d'utilisation de l'échangeur, il s'étend globalement selon une direction inclinée vers le haut à partir de cet orifice. Selon un autre aspect de l'invention, ce tube est pourvu de moyens de refroidissement du fluide caloporteur.

L'invention concerne également un procédé de fabrication d'un échangeur de chaleur tel que précédemment décrit, et plus spécifiquement, un procédé consistant à réaliser, dans une plaque support, des gorges de réception de tubes de circulation de fluide caloporteur, caractérisé en ce qu'il consiste à projeter dans ces gorges, avant mise en place des tubes, un dépôt de métal ou d'alliage de métal en fusion dont la composition est adaptée pour permettre une fixation des tubes sur le dépôt par brasage ou soudage.

Avantageusement, ce dépôt est projeté dans les gorges au moyen d'un jet d'air comprimé. La projection d'un métal en fusion au moyen d'un jet d'air comprimé est parfois dénommée "shoopage". Elle présente l'avantage de permettre une fixation du dépôt sur la surface qui le reçoit, non pas par brasage ou soudage, mais par accrochage mécanique du fait de l'écrasement de la couche formant le dépôt. En particulier, lorsque la projection du métal en fusion a été précédée d'une étape de traitement de la surface de réception du dépôt visant à augmenter sa rugosité, tel que par exemple un sablage, l'accrochage réalisé est particulièrement solide.

L'invention sera mieux comprise et d'autres avantages de celle-ci apparaîtront plus clairement à la lumière de la description qui va suivre d'un mode de réalisation d'un échangeur de chaleur di-phasique pour le refroidissement d'au moins un composant électronique de puissance et de son procédé de fabrication, conformes à l'invention, donnée uniquement à titre d'exemple et faite en référence aux dessins annexés dans lesquels :
- la figure 1 est une représentation schématique de principe en perspective d'un échangeur de chaleur di-phasique conforme à l'invention ;
- la figure 2 est une coupe selon la ligne II-II à la figure 1 ;
- la figure 3 est une coupe partielle selon la ligne III-III à la figure 1 ;
- la figure 4 est une coupe partielle à plus grande échelle selon la ligne IV-IV à la figure 2 et
- la figure 5 est une représentation schématique de principe de l'échangeur de chaleur des figures 1 à 4 lors d'une étape de fabrication.

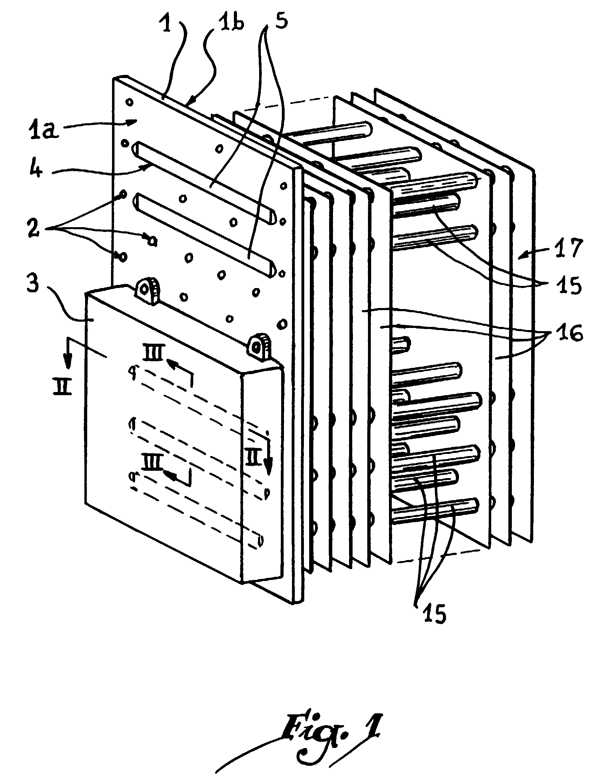

L'échangeur de chaleur représenté à la figure 1 comprend une plaque 1 en aluminium, formant support ou armature, qui présente une première face la pourvue de taraudages 2 de réception de vis de fixation d'une source de chaleur 3 constituée par un composant électronique de puissance, tel qu'un circuit IGBT. L'échangeur représenté à la figure 1 porte un unique circuit 3, il est bien entendu que plusieurs circuits pourraient également être disposés sur la plaque 1 en utilisant d'autres taraudages 2 ménagés sur la face 1a qui est une face d'échange thermique entre la plaque 1 et le ou les composants 3.

Sur sa face la, la plaque 1 est pourvue de plusieurs gorges 4 à l'intérieur desquelles sont disposés des tubes en cuivre 5 permettant la circulation d'un fluide caloporteur, tel que du méthanol ou de l'eau.

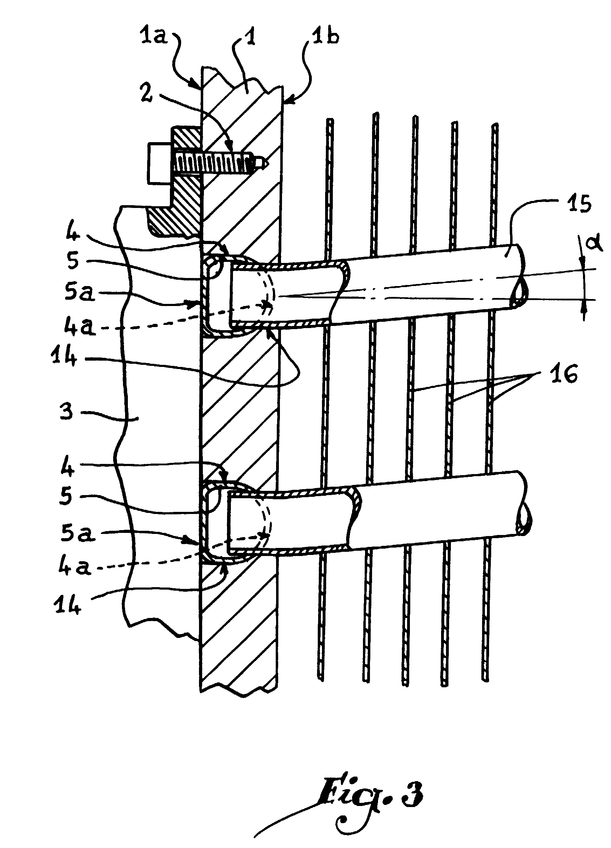

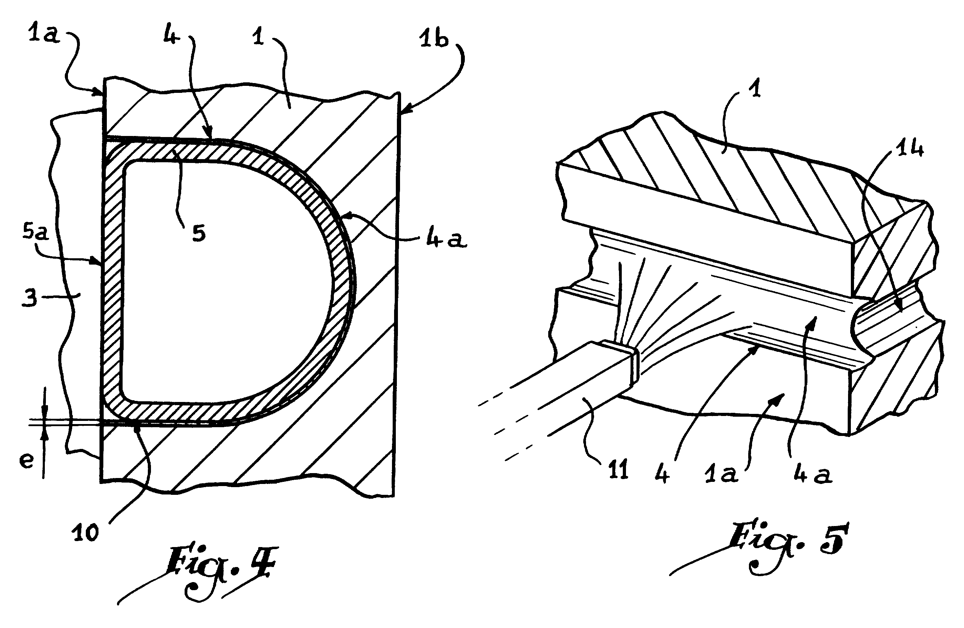

Afin de permettre l'immobilisation des tubes 5 à l'intérieur des gorges 4, et comme représenté schématiquement à la figure 5, on réalise un dépôt 10 de métal dans chaque gorge 4 grâce à un dispositif 11 de projection de métal en fusion par un jet d'air comprimé. Le dispositif 11 peut être du type de ceux utilisés dans les torches à plasma.

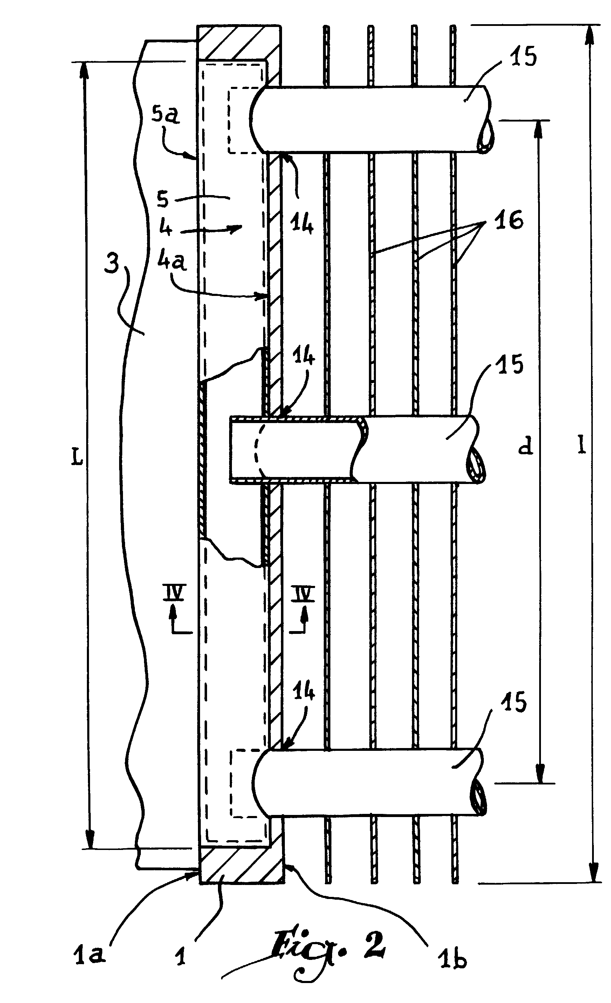

L'épaisseur e du dépôt 10 ainsi obtenu est représentée à la figure 4. Elle dépend de la vitesse de déplacement du dispositif 11 par rapport à la plaque 1 et du nombre de passages de ce dispositif en face de chaque gorge 4. En pratique, l'épaisseur n'est pas inférieure à 1/100ème de mm afin de permettre un accrochage efficace ; elle n'est pas non plus supérieure à 0,5 mm afin de ne pas gêner le transfert thermique entre les tubes 5 et la plaque 1. Des résultats satisfaisants ont été obtenus avec une épaisseur de 0,04 mm.

L'accrochage de la couche de métal en fusion destinée à former le dépôt à l'intérieur de chaque gorge 4 est réalisé du fait de la conversion de l'énergie cinétique obtenue lors de la projection grâce à l'air comprimé. Cette couche s'incruste dans les irrégularités de surface des gorges qui ont été créées lors d'une étape préalable de sablage, par moletage ou par un procédé analogue. Il n'est pas nécessaire qu'il existe une affinité particulière entre le métal constitutif du dépôt 10 et l'aluminium de la plaque 11 puisque l'accrochage réalisé est obtenu par un phénomène essentiellement mécanique.

Par exemple, le dépôt 10 peut être réalisé en cuivre, c'est-à-dire dans un matériau analogue à celui des tubes 5.

Lorsque le dépôt 10 a été effectué dans une gorge 4, il est possible de disposer un tube 5 à l'intérieur de cette gorge et de procéder à l'adjonction d'un mélange d'étain plomb (SnPb) en vue du brasage du tube 5 sur la surface intérieure du dépôt 10, ce qui est possible compte tenu de la nature de ce dépôt. Lorsque la composition du dépôt 10 le permet, les tubes 5 peuvent également être soudés en place, éventuellement sans apport de métal additionnel.

On comprend qu'il est possible d'adapter la composition du dépôt en fonction de la nature du matériau constitutif des tubes 5. Des résultats satisfaisants ont également été obtenus avec des dépôts d'étain, de nickel, ou d'alliages de tels métaux.

Comme il ressort plus particulièrement des figures 2 et 3, le fond 4a des gorges 4 est percé d'orifices 14 qui débouchent sur une face 1b de la plaque 1 opposée à la face 1a. Ces orifices peuvent recevoir des tubes secondaires 15 raccordés fluidiquement au tube primaire 5 de chaque gorge, de sorte que le liquide caloporteur peut librement circuler entre un tube primaire 5 et le ou les tubes secondaires 15 qui lui sont connectés.

Ainsi, dans le cas d'un échangeur di-phasique, le tube primaire 5 constitue la zone d'évaporation du fluide caloporteur, alors que les tubes secondaires 15 constituent des zones de condensation de ce fluide. Pour ce faire, les tubes 15 sont pourvus d'ailettes 16 permettant de dissiper la chaleur du fluide qu'ils contiennent.

Comme il ressort plus particulièrement des figures 3 et 4, les tubes primaires 5 sont légèrement écrasés à l'intérieur de chaque gorge 4. Ils ne dépassent pas de la face 1a de la plaque 1, ce qui permet de disposer le composant 3 en regard de ce tube 5 sur la face la de la plaque 1. Cette disposition permet également d'aligner sensiblement la partie apparente 5a de chaque tube 5 sur la face la de la plaque 1, de sorte qu'elle peut être en contact direct avec la partie correspondante du composant 3.

A la figure 3 qui représente une position d'utilisation de l'échangeur, les tubes secondaires 15 ne sont pas disposés horizontalement mais possèdent un angle d'inclinaison α par rapport à l'horizontale, vers le haut à partir de l'orifice 14. Ceci permet au fluide caloporteur de s'écouler par gravité en direction du tube 5 après sa condensation. L'angle α peut être compris entre 2° et 90° en fonction de la taille des tubes 15 et des ailettes 16. En pratique, un angle α est de l'ordre de 5° s'est avéré très avantageux car il permet un retour efficace du fluide condensé, alors que les tubes 15 s'étendent globalement vers l'arrière à partir de la plaque 1.

Une tôle de renfort 17 est prévue pour être montée sur les extrémités des tubes secondaires 15 distantes des tubes primaires 5 auxquels ils sont reliés afin de rigidifier l'ensemble formé par les tubes 15 et les ailettes 16 qu'ils supportent.

A la figure 2, on note que la longueur L du tube primaire 5 est supérieure à la distance d entre les tubes secondaires 15 les plus éloignés. En effet, les gorges 4 et les tubes 5 qu'elles contiennent peuvent s'étendre sur sensiblement toute la largeur l de la plaque 1, alors que les tubes 15 peuvent être plus resserrés afin de permettre la disposition des ailettes 16 de part et d'autre de ces tubes, sans dépasser en largeur par rapport à la plaque 1, ce qui permet la juxtaposition de plaques analogues sans interférence entre les ailettes. La longueur L des tubes 5 est avantageusement légèrement inférieure à la largeur l de la plaque 1 afin d'obtenir un drain thermique efficace sans fragiliser la plaque 1.

Un échangeur conforme à l'invention peut être utilisé pour constituer le fond d'une armoire comprenant des composants électroniques de puissance, alors que les tubes secondaires 15 qu'il comprend s'étendent vers l'extérieur à partir de la face arrière de cette armoire constituée par une ou plusieurs plaques 1. Les composants compris dans l'armoire sont alors protégés contre d'éventuelles pollutions du gaz de refroidissement circulant entre les ailettes 16.

L'invention a été décrite en référence à un échangeur de chaleur di-phasique pour un composant électronique de puissance. Elle est cependant applicable à d'autres domaines techniques et, notamment, pour la réalisation de panneaux solaires dans lesquels des tubes métalliques doivent être immobilisés à l'intérieur de gorges formées sur une plaque support également métallique.

## Revendications

1. Echangeur de chaleur, notamment pour le refroidissement d'un composant électronique du puissance (3), ledit échangeur comprenant une plaque (1), réalisée dans un premier matériau métallique et pourvue, sur une première face d'échange thermique (1a), de gorges (4) de réception de tubes (5) de circulation d'un fluide caloporteur, lesdits tubes étant réalisés dans un second matériau métallique, caractérisé en ce que lesdites gorges (4) sont revêtues d'un dépôt métallique (10) obtenu par projection (11) d'un métal ou d'un alliage de métal en fusion dans lesdites gorges (4), ledit dépôt ayant une composition permettant une fixation desdits tubes (5) sur ledit dépôt (10) par brasage ou soudage.

2. Echangeur de chaleur selon la revendication 1, caractérisé en ce que ledit dépôt métallique (10) a une épaisseur (e) comprise entre 0,01 et 0,5 mm, de préférence de l'ordre de 0,04 mm.

3. Echangeur de chaleur selon l'une des revendications 1 ou 2, caractérisé en ce que lesdits tubes (5) sont en cuivre alors que ledit dépôt (10) est un dépôt de cuivre, d'étain, de nickel ou d'un alliage de ces métaux.

4. Echangeur de chaleur selon l'une des revendications précédentes, caractérisé en ce que lesdits tubes (5) reçus dans lesdites gorges (4) sont conformés par écrasement (5a), de telle sorte qu'ils ne dépassent pas de ladite première face (1a) de ladite plaque (1) à l'extérieur desdites gorges.

5. Echangeur de chaleur selon l'une des revendications précédentes, caractérisé en ce que le fond (4a) de l'une au moins desdites gorges (4) est pourvu d'au moins un orifice (14) débouchant sur une seconde face (1b) de ladite plaque opposée à ladite première face (1a), un tube secondaire (15) s'étendant à travers ledit orifice, à l'opposé de ladite première face, ledit tube secondaire étant connecté à un tube primaire (5) reçu dans ladite gorge.

6. Echangeur de chaleur selon la revendication 5, caractérisé en ce que ledit tube secondaire (15) s'étendant à travers ledit orifice (14) est conformé de telle sorte que, en position d'utilisation dudit échangeur (figure 3), il s'étend globalement selon une direction inclinée (α) vers le haut à partir dudit orifice.

7. Echangeur de chaleur selon l'une des revendications 5 ou 6, caractérisé en ce que ledit tube secondaire (15) s'étendant à travers ledit orifice (14) est pourvu de moyens (16) de refroidissement du fluide caloporteur.

8. Procédé de fabrication d'un échangeur de chaleur, notamment pour le refroidissement d'un composant électronique de puissance (3), ledit procédé consistant à réaliser, dans une plaque support (1), des gorges (4) de réception de tubes (5) de circulation d'un fluide caloporteur, caractérisé en ce qu'il consiste à projeter dans lesdites gorges, avant mise en place desdits tubes, un dépôt (10) de métal ou d'alliage de métal en fusion dont la composition est adaptée pour permettre une fixation desdits tubes sur ledit dépôt par brasage ou soudage.

9. Procédé de fabrication selon la revendication 8, caractérisé en ce que ledit dépôt (10) de métal ou d'alliage de métal est projeté dans lesdites gorges (4) au moyen d'un jet d'air comprimé.
